# EUROPEAN PATENT APPLICATION

(11) **EP 4 794 496 A1**
(43) Date of publication of application: **19.08.2026**
(21) Application number: 26157473.5
(22) Date of filing: 10.02.2026
(51) Int. Cl.: H10K 59/122, H10K 71/13, H10K 59/35

(54) **DISPLAY DEVICE AND ELECTRONIC DEVICE COMPRISING THE SAME**

(30) Priority: 18.02.2025 KR 20250020923
(71) Applicant: Samsung Display Co., Ltd., Yongin-si, Gyeonggi-do 17113 (KR)
(72) Inventor: HWANG, Jaekwon, 17113 Yongin-si (KR)
(74) Representative: Walaski, Jan Filip

(57) **Abstract**

A display device includes: a substrate comprising pixel columns comprising a plurality of emission areas arranged in a first direction; a pixel electrode on the substrate; a pixel-defining layer surrounding an edge of the pixel electrode and defining the emission areas; a plurality of pixel column defining layers extending along the first direction on the pixel-defining layer and spaced apart from one another in a second direction perpendicular to the first direction; and an emission layer on the pixel electrode; wherein the pixel columns include first pixel columns including a first emission area and a second emission area, on the pixel-defining layer, a waveform defining layer having a regular waveform along the first direction is between two pixel column defining layers that define the first pixel columns, and the first emission area or the second emission area is respectively arranged in a positive half-period or a negative half-period.

## Description

### CROSS-REFERENCE TO RELATED APPLICATION

The present application claims priority to Korean Patent Application No. 10-2025-0020923, filed on 18 February 2025 in the Korean Intellectual Property Office.

### BACKGROUND

### 1. Field

The disclosure relates to a display device and an electronic device including the same.

### 2. Description of the Related Art

With the advancement of information technology, the importance of display devices, which serve as a medium connecting users and information, has become increasingly prominent. For example, the use of display devices such as liquid crystal display (LCD) devices, organic light emitting display (OLED) devices, plasma display (PDP) devices, and quantum dot display devices is increasing.

A display device includes pixels that display visible light. Each of the pixels may include an emission layer. The emission layer may be formed using an inkjet printing method.

The above information disclosed in this Background section is only for enhancement of understanding of the background and therefore the information discussed in this Background section does not necessarily constitute prior art.

### SUMMARY

Aspects of some embodiments include a display device and an electronic device in which two different emission areas are alternately arranged in a single pixel column and the thickness of each emission region is made uniform, thereby reducing display quality degradation and defect rate.

However, the characteristics of embodiments are not limited to the above, and other characteristics not mentioned herein will be more clearly understood by those skilled in the art from the following description.

According to some embodiments, a display device includes: a substrate including pixel columns, each including a plurality of emission areas arranged in a first direction; a pixel electrode disposed on the substrate; a pixel-defining layer surrounding an edge of the pixel electrode and configured to define each of the emission areas; a plurality of pixel column defining layers extending along the first direction on the pixel-defining layer and spaced apart from one another in a second direction perpendicular to the first direction to define the pixel columns; and an emission layer disposed on the pixel electrode; wherein the pixel columns include first pixel columns in each of which a first emission area and a second emission area are alternately arranged, a waveform defining layer having a waveform along the first direction is arranged, on the pixel-defining layer, between two pixel column defining layers that define each of the first pixel columns, and the first emission area or the second emission area is respectively arranged in a positive half-period or a negative half-period of the waveform defining layer.

According to some embodiments, the pixel column defining layers may include a first pixel column defining layer and a second pixel column defining layer that define each of the first pixel columns, the first emission area may be arranged closer to the second pixel column defining layer than to the first pixel column defining layer, the second emission area may be arranged closer to the first pixel column defining layer than to the second pixel column defining layer, and the waveform defining layer may extend between the first emission area and the first pixel column defining layer, between the first emission area and the second emission area, and between the second emission area and the second pixel column defining layer.

According to some embodiments, the waveform defining layer may be arranged spaced apart from the pixel column defining layer.

According to some embodiments, the display device may further include a microchannel defined between a pulse width portion, which is a region of the waveform defining layer extending in the first direction, and the pixel column defining layer closest to the pulse width portion.

According to some embodiments, the microchannel may include a first microchannel configured to connect two of the first emission areas adjacent to the second emission area along the first direction, based on the second emission area, and a second microchannel configured to connect two of the second emission areas adjacent to the first emission area along the first direction, based on the first emission area.

According to some embodiments, the pixel columns may include second pixel columns adjacent to the first pixel column, and each of the second pixel columns may include a plurality of third emission areas arranged along the first direction.

According to some embodiments, the first pixel columns and the second pixel columns may be alternately arranged along the second direction.

According to some embodiments, each of the third emission areas may be arranged adjacent in the second direction to the first emission area and the second emission area adjacent to the first emission area.

According to some embodiments, a length of the third emission area may correspond to a total length of the first emission area and the second emission area adjacent to the first emission area.

According to some embodiments, the upper surfaces of the waveform defining layer and the pixel column defining layers may be lyophobic.

According to some embodiments, the upper surface of the pixel-defining layer may be lyophilic.

According to some embodiments, the upper surface of the pixel column defining layer and the upper surface of the waveform defining layer may be positioned at a higher level than the upper surface of the emission layer.

According to some embodiments, a light-emitting element including the pixel electrode, the emission layer, and a common electrode on the emission layer may be arranged in each of the emission areas.

According to some embodiments of the present disclosure, a display device includes: a substrate including pixel columns, each including a plurality of emission areas arranged in a first direction; a pixel electrode disposed on the substrate; a pixel-defining layer surrounding an edge of the pixel electrode and configured to define each of the emission areas; a plurality of pixel column defining layers extending along the first direction on the pixel-defining layer and spaced apart from one another in a second direction perpendicular to the first direction to define the pixel columns; and an emission layer disposed on the pixel electrode; wherein the pixel columns include first pixel columns in each of which a first emission area and a second emission area are alternately arranged, a waveform defining layer having a waveform along the first direction is arranged, on the pixel-defining layer, between two pixel column defining layers that define each of the first pixel columns, and each edge of the waveform defining layer is placed between the first emission area and the second emission area.

According to some embodiments, the pixel column defining layers may include a first pixel column defining layer and a second pixel column defining layer that define each of the first pixel columns, the first emission area may include a first side adjacent to the first pixel column defining layer, the second emission area may include a second side adjacent to the second pixel column defining layer, and the waveform defining layer may extend between the first side and the first pixel column defining layer, between the first emission area and the second emission area, and between the second side and the second pixel column defining layer.

According to some embodiments, the display device may further include a microchannel defined between a pulse width portion, which is a region of the waveform defining layer extending in the first direction, and the pixel column defining layer closest to the pulse width portion, wherein the microchannel may include a first microchannel configured to connect two of the first emission areas adjacent to the second emission area along the first direction, based on the second emission area, and a second microchannel configured to connect two of the second emission areas adjacent to the first emission area along the first direction, based on the first emission area.

According to some embodiments, the pixel columns may include second pixel columns adjacent to the first pixel column, each of the second pixel columns may include a plurality of third emission areas arranged along the first direction, and the first pixel columns and the second pixel columns may be alternately arranged along the second direction.

According to some embodiments, the upper surfaces of the waveform defining layer and the pixel column defining layers may be lyophobic, and the upper surface of the pixel-defining layer may be lyophilic.

According to some embodiments, the upper surface of the pixel column defining layer and the upper surface of the waveform defining layer may be positioned at a higher level than the upper surface of the emission layer.

According to some embodiments of the present disclosure, an electronic device includes: a display device, a processor, a memory, and a power module, wherein the display device includes: a substrate comprising pixel columns, each comprising a plurality of emission areas arranged in a first direction; a pixel electrode disposed on the substrate; a pixel-defining layer surrounding an edge of the pixel electrode and configured to define each of the emission areas; a plurality of pixel column defining layers extending along the first direction on the pixel-defining layer and spaced apart from one another in a second direction perpendicular to the first direction to define the pixel columns; and an emission layer disposed on the pixel electrode; wherein the pixel columns include first pixel columns in each of which a first emission area and a second emission area are alternately arranged, a waveform defining layer having a waveform along the first direction is arranged, on the pixel-defining layer, between two pixel column defining layers that define each of the first pixel columns, and the first emission area or the second emission area is respectively arranged in a positive half-period or a negative half-period of the waveform defining layer.

### BRIEF DESCRIPTION OF THE DRAWINGS

The accompanying drawings illustrate aspects of some embodiments and together with the disclosure, serve to provide further understanding of the present disclosure, and thus, embodiments should not be construed as being limited to the drawings in which:
FIG. 1 is a plan view illustrating a display device according to some embodiments;
FIG. 2 is an enlarged view of an example of area A shown in FIG. 1;
FIG. 3 is an enlarged view of an example of area B shown in FIG. 2;
FIG. 4 is an enlarged view of another example of area A shown in FIG. 1;
FIG. 5 is an enlarged view of another example of area A shown in FIG. 1;
FIG. 6 is an equivalent circuit diagram of a light-emitting element according to some embodiments;
FIG. 7 is an enlarged view of an example cross-section taken along the line I-I' of FIG. 2;
FIG. 8 is an enlarged view of an example cross-section taken along the line II-II' of FIG. 2;
FIG. 9 is an enlarged view of an example cross-section taken along the line III-III' of FIG. 2;
FIG. 10 is a block diagram of an electronic device according to some embodiments; and
FIG. 11 illustrates schematic diagrams of electronic devices according to some embodiments.

### DETAILED DESCRIPTION

As the disclosure allows for various changes and numerous embodiments, particular embodiments will be shown in the drawings and described in detail in the written description. The characteristics of some embodiments of and a method for accomplishing them will be described more fully with reference to the accompanying drawings, in which aspects of some embodiments are shown. The disclosure may, however, be embodied in many different forms and should not be construed as limited to the embodiments set forth herein.

It will be understood that although the terms first and second are used herein to describe various elements, these elements should not be limited by these terms. These terms are only used to distinguish one element from another element.

As used herein, the singular forms "a," "an," and "the" are intended to include the plural forms as well, unless the context clearly indicates otherwise.

In the examples below, it is to be understood that the terms such as "including," "having," and "comprising" are intended to indicate the existence of the features or components disclosed in the specification, and are not intended to preclude the possibility that one or more other features or components may exist or may be added.

It will be understood that when a unit, region, or component is referred to as being formed on or above another unit, region, or component, it can be directly or indirectly formed on the other unit, region, or component. That is, for example, intervening units, regions, or components may be present.

It will be understood that when an element is referred to as being "connected" or "coupled" to another element, it does necessarily not mean direct and/or fixed connection or coupling of to the two elements or intervening elements may be present, unless it has a clearly different meaning in the context.

In the drawings, the sizes of components may be exaggerated or reduced for convenience of explanation. In other words, since sizes and thicknesses of components in the drawings are arbitrarily illustrated for convenience of explanation, the following embodiments are not limited thereto.

Hereinafter, aspects of some embodiments of the present disclosure will be described in detail with reference to the accompanying drawings. Those components that are the same or are in correspondence are rendered the same reference numeral regardless of the figure number, and redundant explanations are omitted.

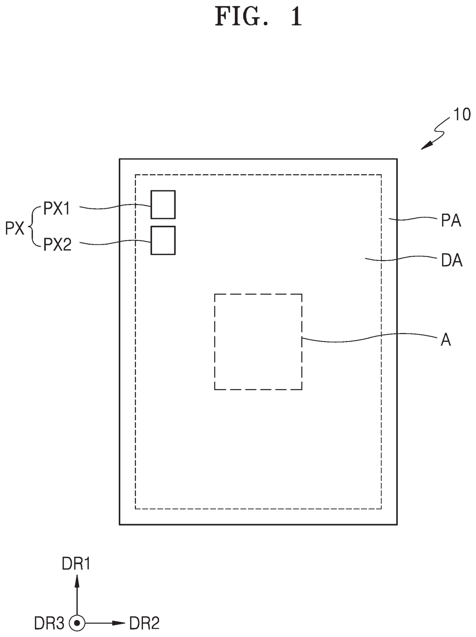

FIG. 1 is a plan view illustrating a display device according to some embodiments.

Referring to FIG. 1, a display device 10 a may be divided into a display area DA and a peripheral area (PA). The display area DA may display images, and the peripheral area PA may be positioned around (e.g., in a periphery or outside a footprint of) the display area DA. For example, the peripheral area PA may surround (e.g., entirely surround) the display area DA.

According to some embodiments, the display device 10 may have a rectangular shape in a plan view. However, embodiments are not necessarily limited thereto, and the display device 10 may have various shapes in a plan view. The plane may be defined from a first direction D1 and a second direction D2 perpendicular to the first direction D1. A third direction D3 may be orthogonal or perpendicular to the plane.

A light-emitting element PX may be placed in the display area DA. The light-emitting element PX may include a first light-emitting element PX1 and a second light-emitting element PX2 adjacent to the first light-emitting element PX1. For example, the second light-emitting element PX2 may be adjacent to the first light-emitting element PX1 in the second direction DR2. However, embodiments are not limited thereto, and the second light-emitting element PX2 may be adjacent to the first light-emitting element PX1 in the first direction DR1, or in both the first direction DR1 and the second direction DR2.

The light-emitting element PX may emit light. For example, the first light-emitting element PX1 and the second light-emitting element PX2 may emit light simultaneously. According to some embodiments, when the first light-emitting element PX1 emits light, the second light-emitting element PX2 may not emit light, and when the second light-emitting element PX2 emits light, the first light-emitting element PX1 may not emit light. The display area DA may display images.

A driver may be arranged in the peripheral area PA. The driver may provide a signal and/or voltage to a pixel P. For example, the driver may include a gate driver, a data driver, and the like.

The display device 10 may include an organic light emitting display device, an inorganic light emitting display device, a quantum dot light emitting display device, a micro light emitting diode (LED) display device, a nano LED display device, a plasma display device, or a liquid crystal display device. Hereinafter, for convenience of description, an example will be given in which the display device 10 is an organic light emitting display device.

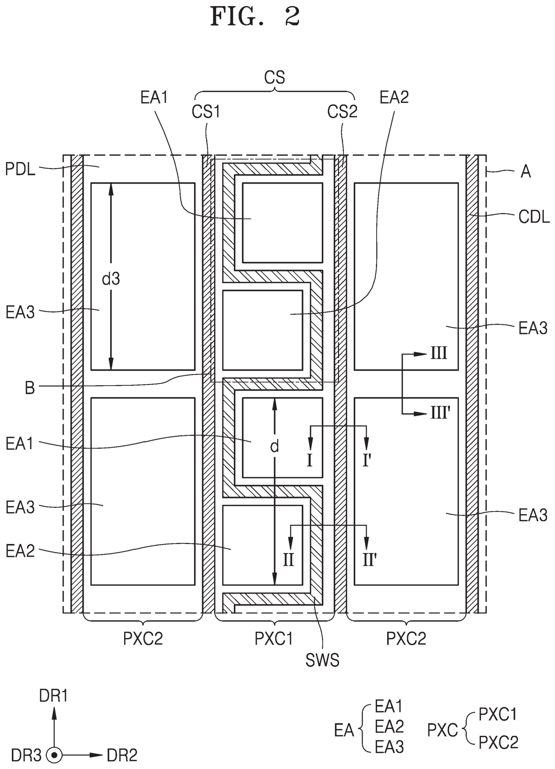

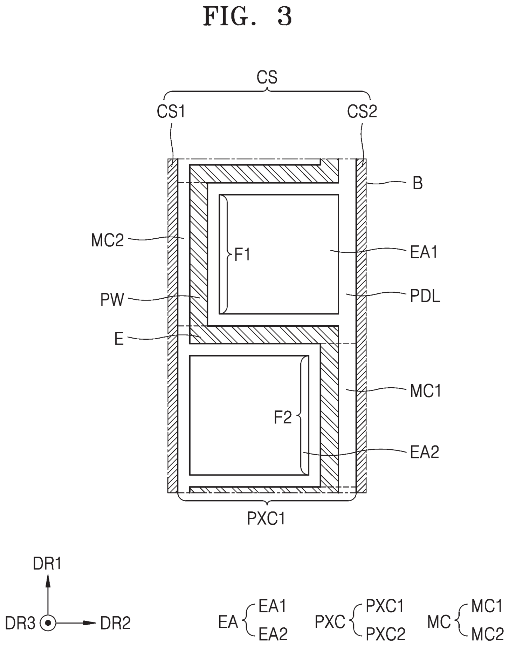

FIG. 2 is an enlarged view of an example of area A shown in FIG. 1, and FIG. 3 is an enlarged view of an example of area B shown in FIG. 2.

Referring to FIGS. 2 and 3, pixel columns PXC, each including a plurality of emission areas EA arranged in a line, may be located on a substrate SUB. In FIG. 2, the emission areas EA are shown as being arranged in the first direction DR1, but embodiments are not limited thereto. That is, when the emission areas EA are arranged in a line in the second direction DR2, each pixel column PXC extends in the second direction DR2, and the plurality of pixel columns PXC may be arranged in the first direction. Hereinafter, the pixel columns PXC will be described based on a case where each pixel column PXC extends in the first direction DR1, the plurality of pixel columns PXC are arranged in the second direction DR2, and the emission areas EA included in each pixel column PXC are arranged in a line in the first direction DR1.

Each emission area EA, which is an area where light is emitted, may be defined by a pixel-defining layer PDL. The emission areas EA may include a first emission area EA1 and a second emission area EA2, and according to some embodiments, may further include a third emission area EA3. The first emission area EA1, the second emission area EA2, and the third emission area EA3 may be areas that emit different colors of light. For example, the first emission area EA1 may emit red light, the second emission area EA2 may emit green light, and the third emission area EA3 may emit blue light, but embodiments are not limited thereto.

The sizes of the emission areas EA may be the same or different from one another. For example, the respective sizes of the first emission areas EA1 may be the same, and the same may apply to the second emission areas EA2 and the third emission areas EA3.

The pixel columns PXC may be defined by pixel column defining layers CS spaced apart from each other in the second direction DR2 perpendicular to the first direction DR1. The pixel column defining layers CS may extend along the first direction DR1 on the pixel-defining layer PDL. In other words, the region between two adjacent pixel column defining layers CS may be referred to as one pixel column PXC. The width of the pixel column defining layer CS may be, for example, 10 µm or more.

Each of the pixel columns PXC may include first pixel columns PXC1 in which first emission areas EA1 and second emission areas EA2 are alternately arranged. The first pixel column PXC1 is defined between two adjacent pixel column defining layers CS, and specifically, the pixel column defining layers CS may include a first pixel column defining layer CS1 and a second pixel column defining layer CS2 that define the first pixel column PXC1.

On the pixel-defining layer PDL, a waveform defining layer SWS having a regular waveform that repeats rising and falling along the first direction DR1 within the first pixel column PXC1 may be arranged. Specifically, the waveform defining layer SWS may have a shape that repeats regularly with a constant period.

According to some embodiments, the waveform defining layer SWS may have a square wave shape.

A square wave is a waveform that sharply alternates between two values with a constant period, and may appear as a combination of horizontal and vertical lines. The square wave may exhibit sharp rises and falls around edges E that have a constant height. In other words, a square wave may be a waveform in which a transition from one state to another occurs immediately and directly.

According to the characteristics of such a square wave, the waveform defining layer SWS may include a pulse width portion PW, which is a region extending in the first direction DR1, and an edge E having a constant height representing a sharp rise or fall.

For example, in one period of the waveform defining layer SWS, one first emission area EA1 and one second emission area EA2 may be arranged. Specifically, the first emission area EA1 or the second emission area EA2 may be respectively arranged in a positive half-period or a negative half-period of the waveform defining layer SWS.

For example, one first emission area EA1 may be arranged in each positive half-period of one waveform defining layer SWS, and one second emission area EA2 may be arranged in each negative half-period of the waveform defining layer SWS. The first emission area EA1 and the second emission area EA2 may be alternately arranged along the first direction DR1.

However, embodiments are not limited thereto, and according to some embodiments, one or more emission areas EA of the same type may be arranged in one positive half-period of the waveform defining layer SWS. In such a case, the same number of emission areas EA of a different type may be arranged in one negative half-period of the waveform defining layer SWS.

In other words, each edge E of the waveform defining layer SWS may be placed between the first emission area EA1 and the second emission area EA2. One type of emission area EA may be arranged in the positive half-period of the waveform defining layer SWS, and another type of emission area EA may be arranged in the negative half-period of the waveform defining layer SWS.

The first emission area EA1 may be arranged closer to the second pixel column defining layer CS2 than to the first pixel column defining layer CS1, and the second emission area EA2 may be arranged closer to the first pixel column defining layer CS1 than to the second pixel column defining layer CS2.

The waveform defining layer SWS may extend between the first emission area EA1 and the first pixel column defining layer CS1, between the first emission area EA1 and the second emission area EA2, and between the second emission area EA2 and the second pixel column defining layer CS2. In other words, the waveform defining layer SWS may be placed between the emission area EA and the pixel column defining layer CS that is farther away from the emission area EA among the two pixel column defining layers CS adjacent to the emission area EA.

The first emission area EA1 may include a first side F1 adjacent to the first pixel column defining layer CS1, and the second emission area EA2 may include a second side F2 adjacent to the second pixel column defining layer CS2. The first side F1 may be a region of the boundary between a pixel electrode ADE that overlaps the first emission area EA1 and the pixel-defining layer PDL that is arranged to cover the edge of the pixel electrode ADE. Similarly, the second side F2 may be a region of the boundary between a pixel electrode ADE that overlaps the second emission area EA2 and the pixel-defining layer PDL that is arranged to cover the edge of the pixel electrode ADE.

The waveform defining layer SWS may extend between the first side F1 and the first pixel column defining layer CS1, between the first emission area EA1 and the second emission area EA2, and between the second side F2 and the second pixel column defining layer CS2.

The waveform defining layer SWS may be arranged spaced apart from the pixel column defining layer CS. A microchannel MC may be defined between the pulse width portion PW of the waveform defining layer SWS and the pixel column defining layer CS closest to the pulse width portion PW.

The microchannel MC may serve as a channel that connects emission areas EA of the same type to each other. The microchannel MC may connect ink placed in emission areas EA of the same type to each other. Due to the microchannel MC, the ink may move between the emission areas EA of the same type, which may result in a uniform overall film thickness across the emission areas EA of the same type. As a result, screen spot issues may be relatively improved, thereby enhancing the display quality of the display device 10, and even when foreign matter is present in a particular emission area EA, ink overflow may be prevented, reduced, or alleviated.

The microchannel MC may include a first microchannel MC1, which connects two first emission areas EA1 adjacent to the second emission area EA2 along the first direction DR1, based on the second emission area EA2, and a second microchannel MC2, which connects two second emission areas EA2 adjacent to the first emission area EA1 along the first direction DR1, based on the first emission area EA1.

That is, the first microchannel MC1 allows for the spreading and filling of ink among the first emission areas EA1 within the same pixel column PXC to be maintained, while reducing defects caused by foreign matter. Similarly, the second microchannel MC2 allows for the spreading and filling of ink among the second emission areas EA2 within the same pixel column PXC to be maintained, while also reducing defects caused by foreign matter.

The pixel columns PXC may include second pixel columns PXC2 adjacent to the first pixel column PXC1. According to some embodiments, the first pixel columns PXC1 and the second pixel columns PXC2 may be alternately arranged along the second direction DR2.

Each of the second pixel columns PXC2 may include a plurality of third emission areas EA3 arranged along the first direction DR1. For example, the third emission area EA3 may be arranged adjacent in the second direction DR2 to a pair of adjacent first emission area EA1 and second emission area EA2. In other words, in a second pixel column adjacent to a first pixel column in which a pair of adjacent first emission area EA1 and second emission area EA2 are arranged, one third emission area EA3 corresponding to the pair of first emission areas EA1 and second emission areas EA2 may be arranged.

In order to increase the resolution of the display device 10, the size of one emission area EA must be reduced. However, in a display device in which emission areas EA of the same type are arranged in each pixel column PXC, the width of the emission area EA is narrow, making it difficult to secure an ink deposition margin when ink is deposited on each emission area EA.

In contrast, in the display device 10 according to some embodiments, in which a third emission area EA3 corresponding to the pair of first emission area EA1 and second emission area EA2 is arranged in the second pixel column PXC2 adjacent to the first pixel column PXC1, enables the width of each emission area EA to be increased even when its overall size is reduced, thereby securing an ink deposition margin and facilitating the manufacturing process, as well as reducing production costs. That is, the display device 10 in which the first emission area EA1, the second emission area EA2, and the third emission area EA3 are arranged as described above may prevent or reduce ink mixing between emission areas EA of different types, thereby reducing the defect rate and achieving high resolution.

For example, the total number of first emission areas EA1, the total number of second emission areas EA2, and the total number of third emission areas EA3 may be the same. According to some embodiments, the length d3 of the third emission area EA3 may correspond to the total length d of the first emission area EA1 and the second emission area EA2 adjacent to the first emission area EA1. The length of the first emission area EA1 and the length of the second emission area EA2 may be the same or different.

In other words, in the first pixel column PXC1, the first emission areas EA1 and second emission areas EA2, which are different types of emission areas EA, may be alternately arranged, separated by the waveform defining layer SWS. Accordingly, the ink injected into the first emission area EA1 and the second emission area EA2 does not mix, and the first emission area EA1 and the second emission area EA2 may emit different colors, thereby relatively improving display quality.

The first emission areas EA1 may be connected to each other by the first microchannel MC1, and the second emission areas EA2 may be connected to each other by the second microchannel MC2. Accordingly, the thickness of the emission areas EA can be constant, and the printing unevenness problem caused by differences in ink volume between adjacent emission areas EA during the printing process may be relatively improved. In addition, even if there is foreign matter in a particular emission area EA or the pixel-defining layer PDL surrounding the emission area EA is defective, a line defect does not occur throughout the pixel column PXC in which the emission area EA is arranged, so that the defect rate of the display device 10 may be relatively improved.

Within the second pixel column PXC2, third emission areas EA3 of the same type as the emission areas EA are arranged so that the difference in volume of ink injected between adjacent third emission areas EA3, which may occur during the manufacturing process, can be controlled. As a result, printing unevenness may be relatively improved, thereby, relatively enhancing the display quality of the display device 10.

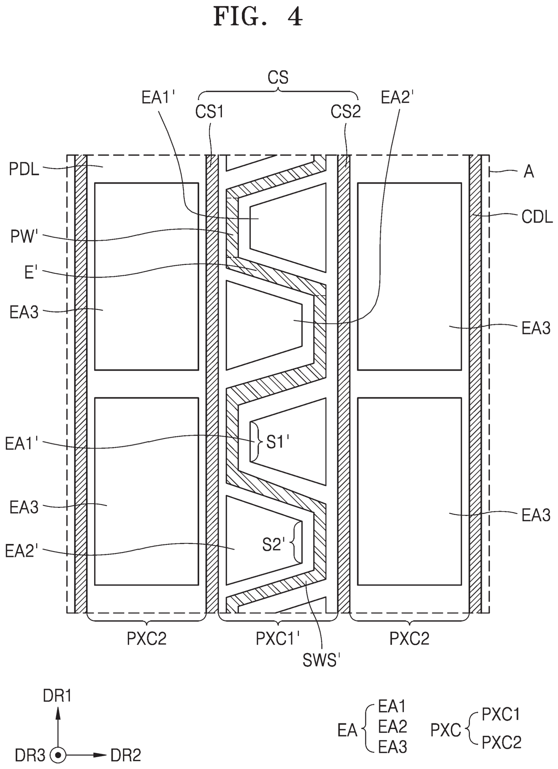

FIG. 4 is an enlarged view of another example of area A shown in FIG. 1.

Referring to FIG. 4, the display device 10 may include a plurality of pixel columns PXC, each including emission areas EA defined by a pixel-defining layer PDL. A pixel column PXC may be defined between adjacent pixel column defining layers CS. The pixel column PXC may include a first pixel column PXC1' in which first emission areas EA1' and second emission areas EA2' are alternately arranged.

On the pixel-defining layer, a waveform defining layer SWS' having a shape similar to a square wave along the first direction DR1 may be arranged within the first pixel column PXC1'.

Specifically, the waveform defining layer SWS' may have the shape of an imperfect square wave with noise, rather than a perfect square wave. In other words, the waveform defining layer SWS' may have the shape of a trapezoidal wave.

A trapezoidal wave is a waveform in which horizontal lines and sloped lines are combined, repeating periodically, and including a rising section, a plateau section, and a falling section within each period. Unlike a square wave, in which the rising and falling changes are abrupt, the trapezoidal wave may have rising and falling transitions that occur linearly.

The waveform defining layer SWS' may include a pulse width portion PW', which extends in the first direction DR1, and an edge E' that rises or falls with a slope. That is, unlike the waveform defining layer SWS shown in FIG. 2, which has the shape of a perfect square wave, the waveform defining layer SWS' shown in FIG. 4 may include a portion that changes with a constant slope rather than rising or falling abruptly.

One first emission area EA1' and one second emission area EA2' may be arranged in one period of the waveform defining layer SWS'. Specifically, a first emission area EA1' or a second emission area EA2' may be respectively arranged in a positive half-period or a negative half-period of the waveform defining layer SWS'. For example, one first emission area EA1' may be arranged in each positive half-period of one waveform defining layer SWS', and one second emission area EA2' may be arranged in each negative half-period of the waveform defining layer SWS'.

In other words, an edge E' of the waveform defining layer SWS' may be placed between the first emission area EA1' and the second emission area EA2'. As a result, the first emission area EA1' and the second emission area EA2' may be alternately arranged along the first direction DR1.

The first emission area EA1' and the second emission area EA2' may correspond to the shape of the waveform defining layer SWS'. In other words, the first emission area EA1' and the second emission area EA2' may have a trapezoidal shape.

The first emission area EA1' may include a first side F1' adjacent to the first pixel column defining layer CS1, and the second emission area EA2' may include a second side F2' adjacent to the second pixel column defining layer CS2.

The waveform defining layer SWS' may extend between the first side F1' and the first pixel column defining layer CS1, between the first emission area EA1' and the second emission area EA2', and between the second side F2' and the second pixel column defining layer CS2.

The display device 10 described in FIG. 4 may equally include the configurations described in FIGS. 2 and 3 and the effects thereof, to the extent that they do not conflict with the above description.

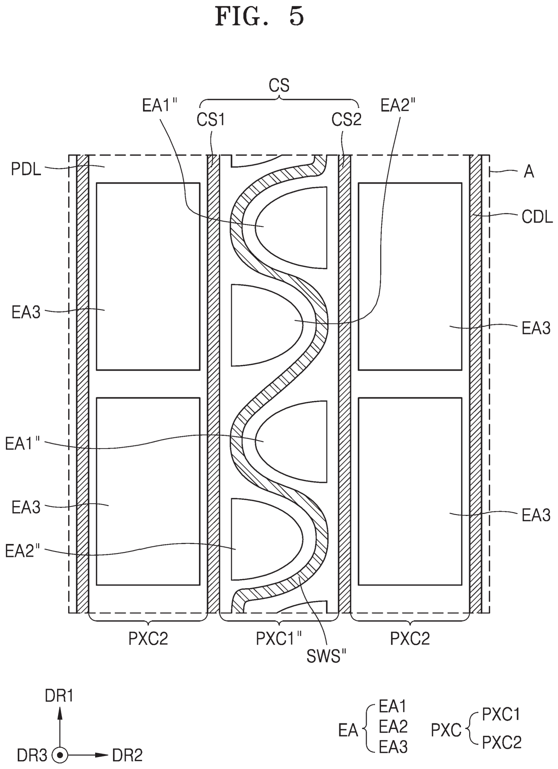

FIG. 5 is an enlarged view of another example of area A shown in FIG. 1.

Referring to FIG. 5, the display device 10 may include a plurality of pixel columns PXC, each including emission areas EA defined by a pixel-defining layer PDL. A pixel column PXC may be defined between adjacent pixel column defining layers CS. The pixel column PXC may include a first pixel column PXC1" in which first emission areas EA1" and second emission areas EA2" are alternately arranged.

On the pixel-defining layer, a waveform defining layer SWS" having a shape similar to a square wave along the first direction DR1 may be arranged within the first pixel column PXC1".

Specifically, the waveform defining layer SWS" may have the shape of an imperfect square wave with noise, rather than a perfect square wave. In other words, the waveform defining layer SWS" may have a shape similar to a sine wave.

The waveform defining layer SWS" may periodically vary up and down while forming a smooth and continuous curve, similar to a sine wave. The waveform defining layer SWS" may repeatedly rise, fall, and rise again at a constant period.

One first emission area EA1" and one second emission area EA2" may be arranged in one period of the waveform defining layer SWS". Specifically, a first emission area EA1" or a second emission area EA2" may be respectively arranged in a positive half-period or a negative half-period of the waveform defining layer SWS". For example, one first emission area EA1" may be arranged in each positive half-period of one waveform defining layer SWS", and one second emission area EA2" may be arranged in each negative half-period of the waveform defining layer SWS". As a result, the first emission area EA1" and the second emission area EA2" may be alternately arranged along the first direction DR1.

The first emission area EA1" and the second emission area EA2"may correspond to the shape of the waveform defining layer SWS". In other words, the first emission area EA1" and the second emission area EA2" may have the shape of an approximate semicircle or semi-ellipse.

The display device 10 described in FIG. 5 may equally include the configurations described in FIGS. 2 and 3 and the effects thereof, to the extent that they do not conflict with the above description.

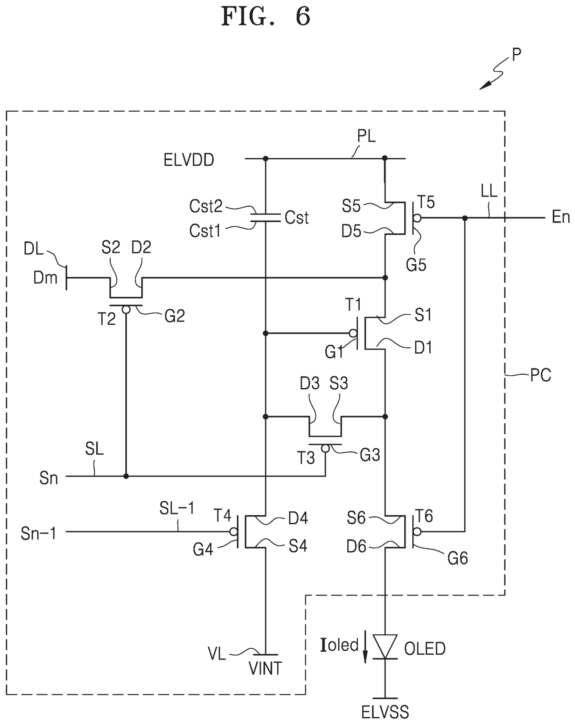

FIG. 6 is an equivalent circuit diagram of a light-emitting element according to some embodiments. Although FIG. 6 illustrates various components in a circuit diagram of a light-emitting element according to some embodiments, embodiments are not limited thereto, and according to various embodiments, the circuit may include additional components, or fewer components.

Referring to FIG. 6, a pixel P includes a pixel circuit PC, which includes first to sixth thin-film transistors T1 to T6 and a storage capacitor Cst, and an organic light emitting diode (OLED) configured to emit light by receiving a driving current through the pixel circuit PC and.

The thin-film transistors TR includes a driving thin-film transistor T1, a switching thin-film transistor T2, a compensation thin-film transistor T3, an initialization thin-film transistor T4, a first emission control thin-film transistor T5, and a second emission control thin-film transistor T6.

The pixel P includes a scan line SL that transmits a scan signal Sn to the switching thin-film transistor T2 and the compensation thin-film transistor T3, a previous scan line SL-1 that transmits a previous scan signal Sn-1 to the initialization thin-film transistor T4, an emission control line LL that transmits an emission control signal En to the first emission control thin-film transistor T5 and the second emission control thin-film transistor T6, a data line DL that intersects the scan line SL and transmits a data signal Dm, a driving voltage line PL that is formed substantially parallel to the data line DL and transmits a first power voltage ELVDD, and an initialization voltage line VL that transmits an initialization voltage VINT for initializing the driving thin-film transistor T1.

A gate electrode G1 of the driving thin-film transistor T1 is connected to a first electrode Cst1 of the storage capacitor Cst. A source electrode S1 of the driving thin-film transistor T1 is connected to the driving voltage line PL via the first emission control thin-film transistor T5. A drain electrode D1 of the driving thin-film transistor T1 is electrically connected to an anode electrode of the OLED via the second emission control thin-film transistor T6. The driving thin-film transistor T1 receives the data signal Dm according to the switching operation of the switching thin-film transistor T2 and supplies a driving current Ioled to the OLED.

A gate electrode G2 of the switching thin-film transistor T2 is connected to the scan line SL. A source electrode S2 of the switching thin-film transistor T2 is connected to the data line DL. A drain electrode D2 of the switching thin-film transistor T2 is connected to the source electrode S1 of the driving thin-film transistor T1 and is connected to the driving voltage line PL via the first emission control thin-film transistor T5. The switching thin-film transistor T2 is turned on in response to the scan signal Sn received through the scan line SL and performs a switching operation to transmit the data signal Dm, which is transmitted through the data line DL, to the source electrode S1 of the driving thin-film transistor T1.

A gate electrode G3 of the compensation thin-film transistor T3 is connected to the scan line SL. A source electrode S3 of the compensation thin-film transistor T3 is connected to the drain electrode D1 of the driving thin-film transistor T1, and is also connected to the anode electrode of the OLED via the second emission control thin-film transistor T6. The drain electrode D3 of the compensation thin-film transistor T3 is connected to the first electrode Cst1 of the storage capacitor Cst, the drain electrode D4 of the initialization thin-film transistor T4, and the gate electrode G1 of the driving thin-film transistor T1. The compensation thin-film transistor T3 is turned on by the scan signal Sn received through the scan line SL and connects the gate electrode G1 and drain electrode D1 of the driving thin-film transistor T1 to each other, thereby forming a diode-connection of the driving thin-film transistor T1.

A gate electrode G4 of the initialization thin-film transistor T4 is connected to the previous scan line SL-1. A source electrode S4 of the initialization thin-film transistor T4 is connected to the initialization voltage line VL. The drain electrode D4 of the initialization thin-film transistor T4 is connected to the first electrode Cst1 of the storage capacitor Cst, the drain electrode D3 of the compensation thin-film transistor T3, and the gate electrode G1 of the driving thin-film transistor T1. The initialization thin-film transistor T4 is turned on in response to the previous scan signal Sn-1 received through the previous scan line SL-1 and performs an initialization operation to initialize the voltage of the gate electrode G1 of the driving thin-film transistor T1 by transmitting the initialization voltage VINT to the gate electrode G1 of the driving thin-film transistor T1.

A gate electrode G5 of the first emission control thin-film transistor T5 is connected to the emission control line LL. A source electrode S5 of the first emission control thin-film transistor T5 is connected to the driving voltage line PL. A drain electrode D5 of the first emission control thin-film transistor T5 is connected to the source electrode S1 of the driving thin-film transistor T1 and the drain electrode D2 of the switching thin-film transistor T2.

A gate electrode G6 of the second emission control thin-film transistor T6 is connected to the emission control line LL. A source electrode S6 of the second emission control thin-film transistor T6 is connected to the drain electrode D1 of the driving thin-film transistor T1 and the source electrode S3 of the compensation thin-film transistor T3. A drain electrode D6 of the second emission control thin-film transistor T6 is electrically connected to the anode electrode of the OLED. The first emission control thin-film transistor T5 and the second emission control thin-film transistor T6 are simultaneously turned on in response to an emission control signal En received through the emission control line LL, so that the first power supply voltage ELVDD is transmitted to the OLED, allowing the driving current Ioled to flow to the OLED.

A second electrode Cst2 of the storage capacitor Cst is connected to the driving voltage line PL. The first electrode Cst1 of the storage capacitor Cst is connected to the gate electrode G1 of the driving thin-film transistor T1, the drain electrode D3 of the compensation thin-film transistor T3, and the drain electrode D4 of the initialization thin-film transistor T4.

The cathode electrode of the OLED is connected to a second power supply voltage ELVSS. The OLED displays an image by emitting light upon receiving the driving current Ioled from the driving thin-film transistor T1.

The pixel P may be, for example, one of a red pixel, a green pixel, or a blue pixel.

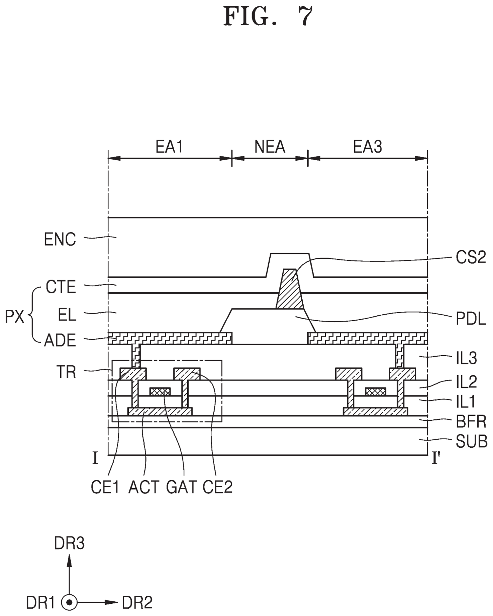

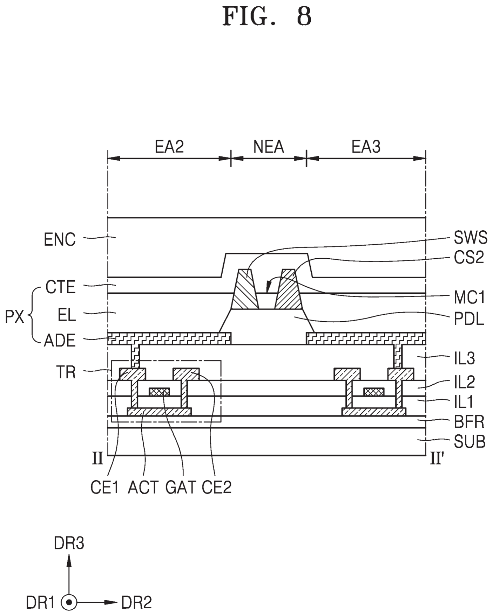

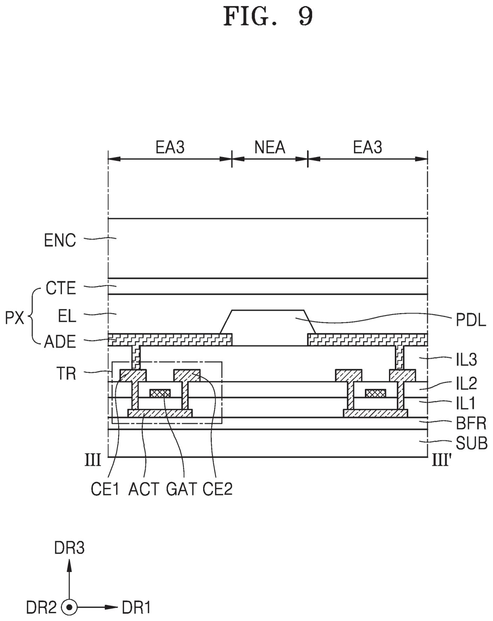

FIG. 7 is an enlarged view of an example cross-section taken along the line I-I' of FIG. 2, FIG. 8 is an enlarged view of an example cross-section taken along the line II-II' of FIG. 2, and FIG. 9 is an enlarged view of an example cross-section taken along the line III-III' of FIG. 2.

Referring to FIGS. 7 to 9, the display device 10 may include a substrate SUB, a buffer layer BFR, thin-film transistors TR, first to third insulating layers IL1, IL2, and IL3, a pixel-defining layer PDL, light-emitting elements PX, and an encapsulation layer ENC.

The substrate SUB may include pixel columns PXC, each including a plurality of emission areas EA arranged in the first direction DR1.

The substrate SUB may include a transparent or opaque material. According to some embodiments, examples of materials that may be used for the substrate SUB may include glass, quartz, plastic, and the like. These materials may be used alone or in combination with one another.

The buffer layer BFR may be placed on the substrate SUB. The buffer layer BFR may prevent or reduce instances or degrees of contaminants or impurities, such as oxygen, moisture, or the like, diffusing to an upper portion of the substrate SUB through the substrate SUB. The buffer layer BFR may include an inorganic insulating material such as a silicon compound or a metal oxide.

According to some embodiments, an additional barrier layer may be placed between the substrate SUB and the buffer layer BFR. The above barrier layer may include an inorganic insulating material.

The thin-film transistors TR may be placed on the substrate SUB, specifically on the buffer layer BFR. Each thin-film transistor TR may include an active pattern ACT, a gate electrode GAT, a first connection electrode CE1, and a second connection electrode CE2.

The active pattern ACT may be placed on the buffer layer BFR. According to some embodiments, the active pattern ACT may include a silicon semiconductor material or an oxide semiconductor material. Examples of the silicon semiconductor material that may be used for the active pattern ACT may include amorphous silicon, polycrystalline silicon, and the like. Examples of the oxide semiconductor material that may be used for the active pattern ACT may include IGZO (InGaZnO), ITZO (InSnZnO), and the like.

According to some embodiments, the first insulating layer IL1 may be located on the buffer layer BFR. The first insulating layer IL1 may cover the active pattern ACT. According to some embodiments, the first insulating layer IL1 may be patterned on the active pattern ACT so as to expose a portion of the active pattern ACT. For example, the first insulating layer IL1 may be patterned on the active pattern ACT so as to overlap with the gate electrode GAT. The first insulating layer IL1 may include an inorganic insulating material. Examples of the inorganic insulating material that may be used for the first insulating layer IL1 may include silicon oxide, silicon nitride, silicon oxynitride, and the like.

The gate electrode GAT may be located on the first insulating layer IL1. According to some embodiments, the gate electrode (GAT) may include a metal, an alloy, a conductive metal oxide, a transparent conductive material, or the like.

A second insulating layer (IL2) can be located on the first insulating layer (IL1). According to some embodiments, the second insulating layer (IL2) can cover the gate electrode (GAT). The second insulating layer (IL2) may include an inorganic insulating material. Examples of inorganic insulating materials that can be used for the second insulating layer (IL2) include silicon oxide, silicon nitride, and silicon oxynitride.

The first connection electrode CE1 and the second connection electrode CE2 may be placed on the second insulating layer IL2. The first connection electrode CE1 and the second connection electrode CE2 may be electrically connected to the active pattern ACT through a contact hole formed in the second insulating layer IL2. Each of the first connection electrode CE1 and the second connection electrode CE2 may include a metal, an alloy, a conductive metal oxide, a transparent conductive material, or the like.

The third insulating layer IL3 may be located on the second insulating layer IL2. The third insulating layer IL3 may cover the first connection electrode CE1 and the second connection electrode CE2. The third insulating layer IL3 may include an organic insulating material. Examples of the organic insulating material that may be used for the third insulating layer IL3 may include photoresist, polyacryl-based resin, polyimide-based resin, polyamide-based resin, siloxane-based resin, acryl-based resin, epoxy-based resin, and the like.

The configuration, arrangement structure, and connection structure of each of the thin-film transistors TR and insulating layers IL1, IL2, and IL3 described with reference to FIG. 7 are merely one example, and various modifications may be made.

The light-emitting element PX is electrically connected to the thin-film transistors TR and may be arranged on a substrate SUB, specifically, on the thin-film transistors TR and the insulating layers IL1, IL2, and IL3.

The light-emitting element PX may include a pixel electrode ADE, an emission layer EL, and a common electrode CTE. One light-emitting element PX may be placed in one emission area EA. That is, in each emission area EA, a light-emitting element PX including a pixel electrode ADE, an emission layer EL, and a common electrode CTE on the emission layer EL may be placed.

The pixel electrode ADE may be located on the third insulating layer IL3. The pixel electrode ADE may be electrically connected to the thin-film transistors TR through a contact hole formed in the third insulating layer IL3. The pixel electrode ADE may include a metal, an alloy, a conductive metal oxide, a transparent conductive material, or the like.

The emission layer EL may be located on the pixel electrode ADE. The emission layer EL may include an organic light-emitting material. According to some embodiments, the emission layer EL may be formed through an inkjet printing process. The organic light-emitting material may include a low molecular weight organic compound or a high molecular weight organic compound. Examples of the low molecular weight organic compound may include copper phthalocyanine, N,N-diphenylbenzidine, tris-(8-hydroxyquinoline)aluminum, and the like. Examples of the high molecular weight organic compound may include poly(3,4-ethylenedioxythiophene), polyaniline, poly-phenylenevinylene, polyfluorene, and the like. These materials may be used alone or in combination with one another.

The pixel-defining layer PDL may be located on the third insulating layer IL3. According to some embodiments, the pixel-defining layer PDL may include an organic insulating material. Examples of the material that may be used for the pixel-defining layer PDL may include polyacrylic resins, polyimide resins, and acrylic resins. These materials may be used alone or in combination with one another.

The pixel-defining layer PDL may surround the edge of the pixel electrode ADE and define each of the emission areas EA. According to some embodiments, the pixel-defining layer PDL may define a pixel aperture that exposes a portion of each pixel electrode ADE. The pixel-defining layer PDL may define the area corresponding to the pixel aperture as the emission area EA, and the area where the pixel-defining layer PDL is arranged may be defined as a non-emission area NEA.

On the pixel-defining layer PDL, a pixel column defining layer CS (CS2) for defining the pixel column PXC and a waveform defining layer SWS having a certain waveform such as a square wave, a trapezoidal wave, or a sine wave within the first pixel column PXC1 may be arranged.

The upper surface of the emission layer EL may be positioned above the upper surface of the pixel-defining layer PDL in the third direction DR3. However, the upper surface of the emission layer EL may be positioned below the upper surface of the pixel column defining layer CS and the upper surface of the waveform defining layer SWS in the third direction DR3.

Referring to FIG. 7, the emission layer EL of the first emission area EA1 and the emission layer EL of the third emission area EA3 may be separated by the pixel column defining layer CS. In other words, the ink constituting the emission layer EL of the first emission area EA1 may not be mixed with the ink constituting the emission layer EL of the third emission area EA3.

Referring to FIG. 8, the emission layer EL of the second emission area EA2 and the emission layer EL of the third emission area EA3 may be separated by the pixel column defining layer CS and the waveform defining layer SWS. That is, even when the upper surface of the emission layer EL is positioned above the upper surface of the pixel-defining layer PDL, the ink constituting the emission layer EL of the second emission area EA2 may not be mixed with the ink constituting the emission layer EL of the third emission area EA3.

Additionally, a first microchannel MC1 may be formed in the emission layer EL between the waveform defining layer SWS and the second pixel column defining layer CS2. That is, the emission layer EL between the waveform defining layer SWS and the second pixel column defining layer CS2 may be connected to the emission layers EL of the first emission areas EA1 before and after it in the first direction DR1. Due to the first microchannel MC1, the emission layers EL of all the first emission areas EA1 within a single first pixel column PXC1 may be connected.

Referring to FIG. 9, only a plurality of third emission areas EA3 may be arranged in the second pixel column PXC2. Since the upper surface of the emission layer EL is higher than the upper surface of the pixel-defining layer PDL, the emission layers EL of the third emission areas EA3 arranged in a single second pixel column may all be connected.

In order for the upper surfaces of the emission layers EL of emission areas EA of the same type within a single pixel column PXC to have a uniform height, the upper surface of at least the pixel-defining layer PDL may be lyophilic. The term "lyophilic" may refer to a property of having high affinity for the ink forming the emission layer EL.

In another example, the pixel-defining layer PDL itself may be lyophilic, or the surface of the pixel-defining layer PDL may be surface-treated to have lyophilic properties. As a result, the display device 10 may have clearly defined emission areas EA while reducing screen spot issues, thereby relatively improving display quality.

However, since the pixel column defining layer CS separates the pixel columns PXC and the waveform defining layer SWS must separate the emission layers EL of emission areas EA of different types within a single pixel column PXC, the upper surface of the waveform defining layer SWS and the upper surface of the pixel column defining layer CS may be lyophobic. In this specification, the term "lyophobic" may refer to a property of repelling the ink forming a certain emission layer EL and resisting infiltration of the ink.

The upper surface of the waveform defining layer SWS and the upper surface of the pixel column defining layer CS may be lyophobic, thereby preventing or reducing the ink of the emission layer EL of one emission area EA from overflowing into the emission layer EL of another emission area EA of a different type. As a result, color mixing between emission layers EL of emission areas EA of different types may be prevented or reduced and the defect rate and display quality of the display device 10 may be relatively improved.

The common electrode CTE may be located on the emission layer EL, the pixel-defining layer PDL, the pixel column defining layer CS, and the waveform defining layer SWS. The common electrode CTE may include a conductive material such as a metal, an alloy, a conductive metal nitride, a conductive metal oxide, a transparent conductive material, or the like. The common electrode CTE may have a single-layer structure or a multi-layer structure including multiple conductive layers.

The encapsulation layer ENC may be located on the common electrode CTE. The encapsulation layer ENC may cover the light-emitting element PX. According to some embodiments, the encapsulation layer ENC may include at least one inorganic encapsulation layer and at least one organic encapsulation layer. According to some embodiments, the encapsulation layer ENC may include a first inorganic encapsulation layer located on the common electrode CTE, an organic encapsulation layer located on the first inorganic encapsulation layer, and a second inorganic encapsulation layer located on the organic encapsulation layer.

The display device 10 according to some embodiments may be applied to various electronic devices 1000. An electronic device 1000 according to some embodiments may include the display device 10 described above, and may further include modules or devices with additional functions, in addition to the display device 10.

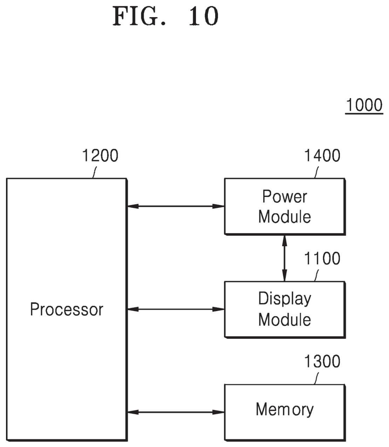

FIG. 10 is a block diagram of an electronic device according to some embodiments. Referring to FIG. 10, an electronic device 1000 according to some embodiments may include a display module 1100, a processor 1200, a memory 1300, and a power module 1400.

The processor 1200 may include at least one of a central processing unit (CPU), an application processor (AP), a graphics processing unit (GPU), a communication processor (CP), an image signal processor (ISP), or a controller.

Data information necessary for the operation of the processor 1200 or display module 1100 may be stored in the memory 1300. When the processor 1200 executes an application stored in the memory 1300, an image data signal and/or an input control signal may be transmitted to the display module 1100, and the display module 1100 may process the received signal and output image information through a display screen.

The power module 1400 may include a power supply module, such as a power adapter or a battery device, and a power conversion module that converts power supplied by the power supply module to generate power required for the operation of the electronic device 1000.

At least one of the components of the above-described electronic device 1000 may be included in the display device 10 according to the embodiments described above. Additionally, some individual modules that are functionally included in a single module may be partially included in the display device, while others may be provided separately from the display device. For example, the display device 10 may include the display module 1100, while the processor 1200, the memory 1300, and the power module 1400 may be provided as other devices within the electronic device 1000, rather than within the display device 10.

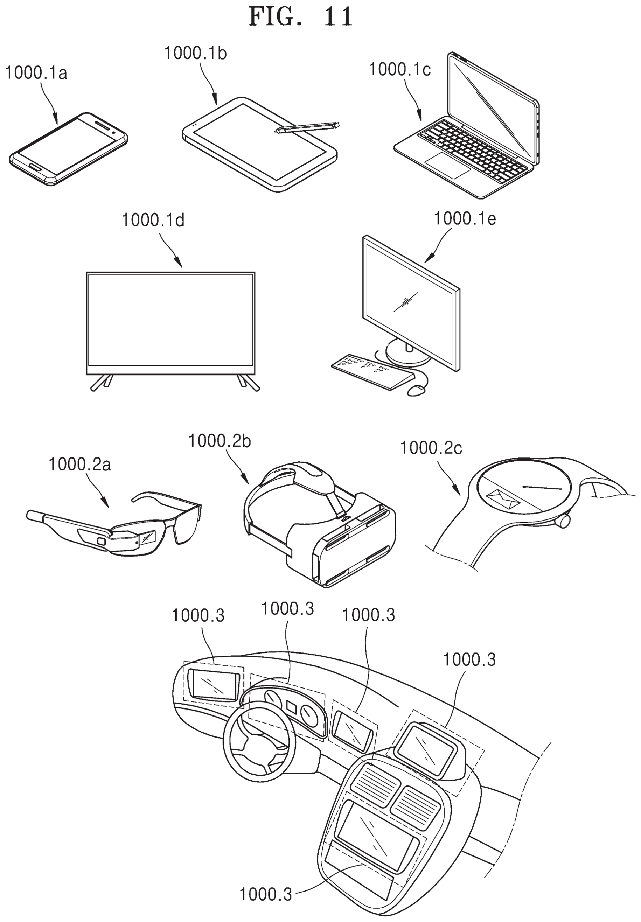

FIG. 11 illustrates schematic diagrams of electronic devices according to some embodiments.

Referring to FIG. 11, various electronic devices to which display devices 10 according to the embodiments are applied may include not only image display electronic devices such as a smart phone 1000.1a, a tablet PC 1000.1b, a laptop computer 1000.1c, a TV 1000.1d, and a desk monitor 1000.1e, but also wearable electronic devices including a display module, such as smart glasses 1000.2a, a head mounted display 1000.2b, and a smart watch 1000.2c, and vehicle electronic devices 1000.3 including a display module, such as a room mirror display, and a center information display (CID) arranged on an instrument panel, a center fascia, or a dashboard of a vehicle.

The display device and electronic device according to some embodiments may have relatively improved display quality and a relatively reduced defect rate.

However, it will be appreciated by one of ordinary skill in the art that the effects that can be achieved with the disclosure are not limited to what has been particularly described hereinabove and other aspects of some embodiments of the present disclosure will be more clearly understood from the following description taken in conjunction with the accompanying drawings.

The embodiments described above may be implemented independently; however, it is evident that the structures of the various embodiments may also be applied in combination with one another.

Although the disclosure has been described with reference to the embodiments illustrated in the drawings, these embodiments are merely exemplary. One of ordinary skill in the art will understand that various modifications and equivalent embodiments will be apparent from this description. Accordingly, the inventive concept is not limited to such embodiments, but rather to the broader scope of the presented claims and various obvious modifications and equivalent arrangements.

The particular implementations shown and described herein are illustrative examples of the embodiments and are not intended to otherwise limit the scope of the embodiments in any way. Moreover, no element is essential for implementation of the embodiments unless the element is specifically described as "essential" or "critical".

The use of the terms "a" and "an" and "the" and similar referents in the context of describing the present invention (especially in the context of the following claims) are to be construed to cover both the singular and the plural. Furthermore, recitation of ranges of values herein are merely intended to serve as a shorthand method of referring individually to each separate value falling within the range, unless otherwise indicated herein, and each separate value is incorporated into the specification as if it were individually recited herein. Also, the steps of all methods described herein can be performed in any suitable order unless otherwise indicated herein or otherwise clearly contradicted by context. Embodiments of the present disclosure are not limited to the described order of the operations. The use of any and all examples, or exemplary language (e.g., "such as") provided herein, is intended merely to better illuminate the disclosure and does not pose a limitation on the scope of embodiments according to the present disclosure unless otherwise claimed. Numerous modifications and adaptations will be readily apparent to one of ordinary skill in the art without departing from the scope of the invention as defined by the claims.

## Claims

1. A display device comprising:
a substrate comprising pixel columns, each comprising a plurality of emission areas arranged in a first direction;
a pixel electrode on the substrate;
a pixel-defining layer surrounding an edge of the pixel electrode and configured to define each of the emission areas;
a plurality of pixel column defining layers extending along the first direction on the pixel-defining layer and spaced apart from one another in a second direction perpendicular to the first direction to define the pixel columns; and
an emission layer on the pixel electrode;
wherein the pixel columns include first pixel columns in each of which a first emission area and a second emission area are alternately arranged,
on the pixel-defining layer, a waveform defining layer having a regular waveform along the first direction is arranged between two pixel column defining layers that define each of the first pixel columns, and
the first emission area or the second emission area is respectively arranged in a positive half-period or a negative half-period of the waveform defining layer.

2. The display device of claim 1,
wherein the pixel column defining layers comprise a first pixel column defining layer and a second pixel column defining layer that define each of the first pixel columns,
the first emission area is closer to the second pixel column defining layer than to the first pixel column defining layer,
the second emission area is closer to the first pixel column defining layer than to the second pixel column defining layer, and
the waveform defining layer extends between the first emission area and the first pixel column defining layer, between the first emission area and the second emission area, and between the second emission area and the second pixel column defining layer.

3. The display device of claim 1 or 2,
wherein the waveform defining layer is spaced apart from the pixel column defining layer.

4. The display device of any one of claims 1 to 3, further comprising:
a microchannel defined between a pulse width portion, which is a region of the waveform defining layer extending in the first direction, and the pixel column defining layer closest to the pulse width portion.

5. The display device of claim 4,
wherein the microchannel comprises a first microchannel configured to connect two of the first emission areas adjacent to the second emission area along the first direction, based on the second emission area, and
a second microchannel configured to connect two of the second emission areas adjacent to the first emission area along the first direction, based on the first emission area.

6. The display device of any one of the preceding claims,
wherein the pixel columns comprise second pixel columns adjacent to the first pixel columns, and
each of the second pixel columns comprises a plurality of third emission areas arranged along the first direction.

7. The display device of claim 6, wherein the first pixel columns and the second pixel columns are alternately arranged along the second direction.

8. The display device of claim 6 or 7, wherein each of the third emission areas is arranged adjacent in the second direction to the first emission area and the second emission area adjacent to the first emission area.

9. The display device of claim 6, wherein the length of the third emission areas corresponds to a total length of the first emission area and the second emission area adjacent to the first emission area.

10. The display device of any one of the preceding claims, wherein upper surfaces of the waveform defining layer and the pixel column defining layers are lyophobic.

11. The display device of any one of the preceding claims, wherein an upper surface of the pixel-defining layer is lyophilic.

12. The display device of any one of the preceding claims, wherein an upper surface of the pixel column defining layer and an upper surface of the waveform defining layer are positioned at a higher level than an upper surface of the emission layer.

13. The display device of any one of the preceding claims, wherein a light-emitting element comprising the pixel electrode, the emission layer, and a common electrode on the emission layer is arranged in each of the emission areas.

14. The display device according to any one of the preceding claims,
wherein an edge of the waveform defining layer is between the first emission area and the second emission area.

15. An electronic device comprising:
a display device according to any one of the preceding claims;
a processor;
a memory; and
a power module.
